# FASCICULE DE BREVET EUROPEEN

(11) **EP 3 029 476 B1**
(45) Date de publication et mention de la délivrance du brevet: **16.10.2019**
(21) Numéro de dépôt: 15174215.2
(22) Date de dépôt: 29.06.2015
(51) Int. Cl.: G01R 31/327, G01R 31/12

(54) **PROCÉDÉ POUR TESTER L'ENSEMBLE DE LA CHAÎNE DE PROTECTION DANS UN APPAREILLAGE DE PROTECTION ÉLECTRIQUE MOYENNE TENSION, ET APPAREILLAGE POUR LA MISE EN OEUVRE D'UN TEL PROCÉDÉ.**
VERFAHREN ZUM TESTEN DER GESAMTEN SCHUTZKETTE IN EINEM ELEKTRISCHEN MITTELSPANNUNGSSCHUTZGERÄT, UND GERÄT ZUR UMSETZUNG DIESES VERFAHRENS
METHOD FOR TESTING THE WHOLE OF THE PROTECTION CHAIN IN A MEDIUM-VOLTAGE ELECTRICAL PROTECTION APPLIANCE, AND APPLIANCE FOR THE IMPLEMENTATION OF SUCH A METHOD.

(30) Priorité: 23.09.2014 FR 1458952
(43) Date de publication de la demande: 08.06.2016
(73) Titulaire: Schneider Electric Industries SAS, 92500 Rueil-Malmaison (FR)
(72) Inventeur: PERRONE, Michel, 38050 GRENOBLE (FR); FILIPPI, Gianluca, 38050 GRENOBLE (FR); KAMAL, Mohammed Hashir, 38050 GRENOBLE (FR)
(74) Mandataire: Colette, Marie-Françoise

(56) Documents cités:
- EP-A1- 0 843 332
- EP-A1- 2 662 697
- EP-A1- 2 700 962
- WO-A1-2004/095667
- DE-U1- 29 720 284
- GB-A- 2 124 786
- US-A- 4 105 965
- US-B1- 6 295 190
- NILS WÄCKLÉN ET AL: "High voltage circuit breaker testing with dual grounding", ENERGIZE, no. May 2008, 1 mai 2008 (2008-05-01), pages 52-55, XP055054228,
- ZORAN STANISIC: "Method for static and dynamic resistance measurements of HV circuit breaker", 2011 2ND IEEE PES INTERNATIONAL CONFERENCE AND EXHIBITION ON INNOVATIVE SMART GRID TECHNOLOGIES (ISGT EUROPE 2011) : MANCHESTER, UNITED KINGDOM, 5 - 7 DECEMBER 2011, IEEE, PISCATAWAY, NJ, 5 décembre 2011 (2011-12-05), pages 1-5, XP032136558, DOI: 10.1109/ISGTEUROPE.2011.6162618 ISBN: 978-1-4577-1422-1
- EDSEL ATIENZA: "Testing and troubleshooting IEC 61850 GOOSE-based control and protection schemes", PROTECTIVE RELAY ENGINEERS, 2010 63RD ANNUAL CONFERENCE FOR, IEEE, PISCATAWAY, NJ, USA, 29 mars 2010 (2010-03-29), pages 1-7, XP031679124, ISBN: 978-1-4244-6073-1
- ANDREW LEONI ET AL: "Practical Tips for MEDIUM-VOLTAGE Equipment Check Out", IEEE INDUSTRY APPLICATIONS MAGAZINE, IEEE SERVICE CENTER, PISCATAWAY, NJ, US, vol. 8, no. 6, 1 novembre 2002 (2002-11-01), pages 37-44, XP011093346, ISSN: 1077-2618
- OLIVER PETERSON ET AL: "Proper testing of protection systems ensures against false tripping and unnecessary outages", PULP AND PAPER INDUSTRY TECHNICAL CONFERENCE, 2009. PPIC '09. CONFERENCE RECORD OF 2009 ANNUAL, IEEE, PISCATAWAY, NJ, USA, 21 juin 2009 (2009-06-21), pages 70-83, XP031499034, ISBN: 978-1-4244-3464-0

## Description

### DOMAINE TECHNIQUE

La présente invention concerne un procédé pour tester l'ensemble de la chaîne de protection dans un appareillage de protection électrique moyenne tension à isolation gazeuse, ledit appareillage comportant un disjoncteur,

### ETAT DE LA TECHNIQUE ANTERIEURE

Les disjoncteurs moyenne tension ont largement dépassé en terme de volume d'appareils installés sur site, les dispositifs de protection traditionnels utilisant des fusibles.

Même si les disjoncteurs offrent des fonctionnalités et des protections efficaces lors de court-circuits sur les réseaux électriques, le test des relais de protection devient un enjeu important et obligatoire pour garantir la fiabilité d'un poste électrique. L'ouverture du circuit en cas de défaut fait partie d'un programme de maintenance incontournable. Le test de l'ensemble de la chaîne de protection incluant les capteurs de protection, le relais, le déclencheur, et le mécanisme du disjoncteur est primordial pour la protection du réseau électrique. Ce test est communément appelé test de l'injection primaire car le principe est d'injecter un courant sur le circuit principal.

Ce test de la protection des disjoncteurs intégrant l'ensemble de la chaîne des capteurs, relais et actionneur est une exigence forte des clients. En effet, ce test permet la vérification de la protection.

Traditionnellement, pour réaliser ce test, différentes solutions sont utilisées, lesquelles ne proposent pas de test direct de l'ensemble de la chaîne de protection, c'est-à-dire un test permettant d'envoyer une valeur exacte de courant.

On connaît par exemple les tests de déclenchement réalisés sur le secondaire du relais.

On connaît également les tests réalisés sur le primaire du relais avec des artifices comme par exemple des spires passant à travers le capteur et impliquant l'application d'un ratio en fonction du courant injecté. Dans ce cas, la valeur d'injection du courant de test n'est pas une valeur directe. Or, les exigences du client pour le test à différentes valeurs précises de courant correspondent à un réel besoin.

Par ailleurs, un autre inconvénient de cette solution tient en ce que dans le cas de l'utilisation d'un système avec spire, il est nécessaire de remonter la filerie de test sur la face avant de l'appareillage.

De plus, la procédure de ce test est longue et complexe et nécessite d'ouvrir le compartiment du transformateur pour brancher la source de courant directement sur les transformateurs. Par ailleurs, les transformateurs de courant traditionnels à bobinage ne sont pas insensibles à l'environnement et aux ambiances humides et chaudes, lesquelles favorisent les décharges diélectriques de surface. En effet, les parties actives sous tension ne sont pas protégées et sont dans l'air. Tout ceci a pour effet de réduire très nettement la durée de vie de l'appareillage lorsqu'il est installé dans des conditions sévères.

On connaît également le document EP 2 700 962 décrivant un procédé de test d'une résistance d'un contact de commutation d'un disjoncteur.

### EXPOSE DE L'INVENTION

La présente invention résout ces problèmes et propose un procédé de test de la chaîne de protection d'un appareil de protection électrique moyenne tension, permettant de réaliser un test direct et complet de la chaine de protection, ne nécessitant aucun artifice supplémentaire, ni accès aux transformateurs, ni ouverture de porte d'aucun compartiment, ainsi qu'un appareil de protection électrique moyenne tension pour la mise en oeuvre de ce procédé, lequel est complètement insensible aux ambiances sévères lors de la réalisation du test.

A cet effet, la présente invention a pour objet un procédé selon la revendication 1.

Selon une caractéristique particulière, l'on injecte ce courant sur des doigts d'injection initialement présents sur le circuit électrique du sectionneur amont, lesquels étant initialement prévus pour réaliser le test des câbles par injection d'une tension dite de test des câbles.

Selon une autre caractéristique, les deux sectionneurs précités comportent chacun des moyens de mise à la terre du circuit correspondant, les points de raccordement électriques précités sont situés respectivement sur les circuits de mise à la terre correspondant à ces moyens de mise à la terre, et préalablement au branchement des moyens d'injection, les deux circuits électriques de mise à la terre sont fermés.

Selon une autre caractéristique, la mise à la terre s'effectue, pour chacun des sectionneurs, par l'intermédiaire d'un collecteur interposé entre la terre et le point de raccordement correspondant, et préalablement à l'injection de courant et après la fermeture du disjoncteur, les collecteurs précités sont retirés.

Selon une réalisation particulière, les sectionneurs respectivement amont et aval sont des sectionneurs comportant une position de mise à la terre.

Selon une autre réalisation, les sectionneurs amont et aval sont reliés électriquement en aval respectivement à un sectionneur de terre amont et à un sectionneur de terre aval, lesdits sectionneurs de terre étant reliés électriquement à la terre respectivement au moyen d'un collecteur de terre, caractérisé en ce que dans la première étape , l'on ouvre tout d'abord le disjoncteur, puis le sectionneur amont, puis le sectionneur aval, puis l'on ferme le sectionneur de terre amont, puis l'on ferme le sectionneur de terre aval, puis l'on vient brancher les moyens d'injection précités sur le premier point de raccordement.

Selon une caractéristique particulière, lors de la seconde étape, l'on ferme le disjoncteur, l'on retire les collecteurs de terre de manière que les circuits de mise à la terre soient ouverts, et l'on injecte le courant.

La présente invention a encore pour objet un appareillage de protection électrique moyenne tension pour la mise en oeuvre d'un procédé comportant les caractéristiques précédemment mentionnées prises seules ou en binaison, selon la revendication 8. Cet appareillage comporte un disjoncteur monté en série en amont avec un sectionneur dit amont, et en aval avec un sectionneur dit aval, au moins un doigt d'injection situé(s) en un point de raccordement électrique dit premier situé sur le circuit électrique du sectionneur dit amont, au moins un doigt d'injection situé(s) en un point de raccordement électrique dit second situé sur le circuit électrique du sectionneur dit aval, un moyen d'injection d'un courant sur le premier point de raccordement électrique, et un moyen de mesure du courant circulant entre le point de raccordement dit premier et le point de raccordement électrique dit second.

Selon une caractéristique particulière, les sectionneurs amont et aval précités sont des sectionneurs à trois positions comportant une position de mise à la terre. Selon une autre caractéristique, les deux sectionneurs respectivement amont et aval sont reliés électriquement respectivement en aval à deux sectionneurs de terre respectivement amont et aval par l'intermédiaire respectivement d'un collecteur de terre amont et d'un collecteur de terre aval.

Selon une autre caractéristique, cet appareillage comporte un capteur de protection disposé à la sortie du disjoncteur, le courant lors du test traversant alors directement le capteur sur son circuit primaire.

Selon une autre caractéristique, le capteur de protection est du type à basse tension, est monté autour des traversées appartenant à un premier jeu de traversées associées au disjoncteur, et comporte un second capteur dit de mesure de courant également du type à basse tension et monté autour d'un second jeu de traversées relié électriquement et mécaniquement phase par phase au premier jeu de traversées, par l'intermédiaire d'un jeu de barre isolé blindé.

### BREVE DESCRIPTION DES DESSINS

Mais d'autres avantages et caractéristiques de l'invention apparaîtront mieux dans la description détaillée qui suit et se réfère aux dessins annexés donnés uniquement à titre d'exemple et dans lesquels :
- La figure 1 illustre le schéma électrique d'un appareil de protection électrique moyenne tension selon une réalisation particulière de l'invention,
- La figure 2 est une vue en perspective de cet appareillage électrique moyenne tension, vu de l'avant, les portes des compartiments étant fermés,
- La figure 3 est une vue en perspective du même appareillage, les portes des compartiments étant ouvertes,
- La figure 4 est une vue en perspective d'une partie de ce même appareillage, vu de l'avant,
- Les figures 5 et 6 représentent le schéma électrique d'un appareillage électrique moyenne tension selon respectivement deux réalisations particulières de l'invention, ledit appareillage étant en dehors du mode test et présentant, pour l'appareillage de la figure 5, un départ à droite, et pour l'appareillage de la figure 6, un départ à gauche,
- La figure 7 représente le même schéma que celui de la figure 6, l'appareillage étant en mode « test ».

### EXPOSE DETAILLE DE PLUSIEURS MODES DE REALISATION PARTICULIERS DE L'INVENTION

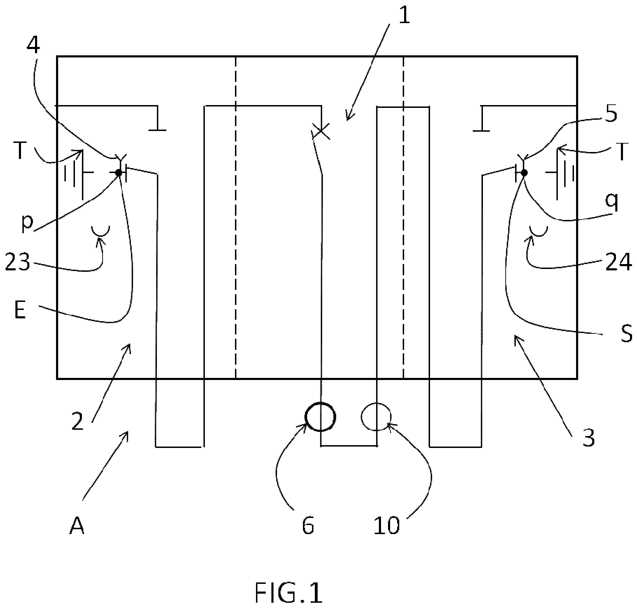

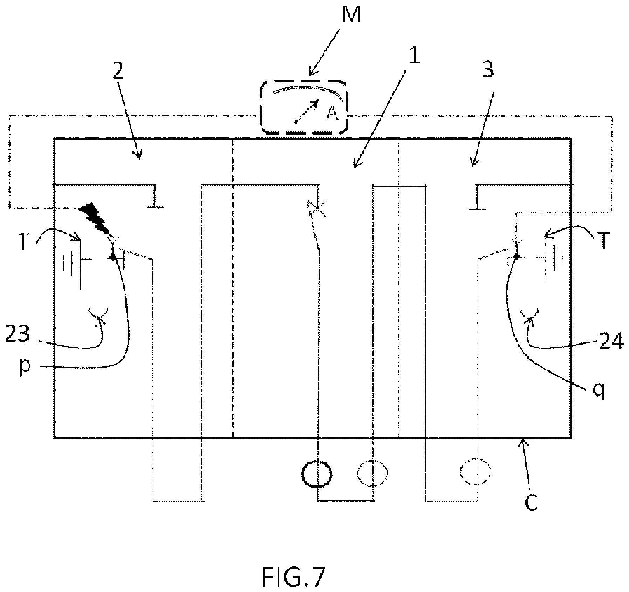

Sur la figure 1, un appareillage de protection électrique moyenne tension A à isolation dans le gaz selon un mode de réalisation particulier de l'invention comporte un disjoncteur 1 relié électriquement en amont à un sectionneur amont 2, et en aval, à un sectionneur aval 3, les dits sectionneurs 2,3 respectivement amont et aval comportant en un point de raccordement électrique p,q à leur circuit électrique, respectivement plusieurs doigts d'injection amont 4 et plusieurs doigts d'injection aval 5. Ces doigts sont les doigts d'injection habituellement utilisés pour l'injection d'une tension lors de la réalisation du test des câbles. Selon cette réalisation particulière de l'invention, ces deux sectionneurs comportent une position de mise à la terre T de leurs circuits respectifs. L'invention consiste à injecter sur ces doigts un courant destiné à traverser le circuit principal du disjoncteur en mesurant en même temps ce courant au moyen d'un dispositif de mesure M (fig.7) du courant branché entre l'entrée E et la sortie S de l'appareil. Ce procédé permet d'injecter directement une valeur de courant précise à l'aide d'une source de courant.

Tel que ceci apparaît sur la figure 1, ce disjoncteur 1 comporte en aval un capteur de courant de protection 6 lié au relais pour le déclenchement du disjoncteur 1.

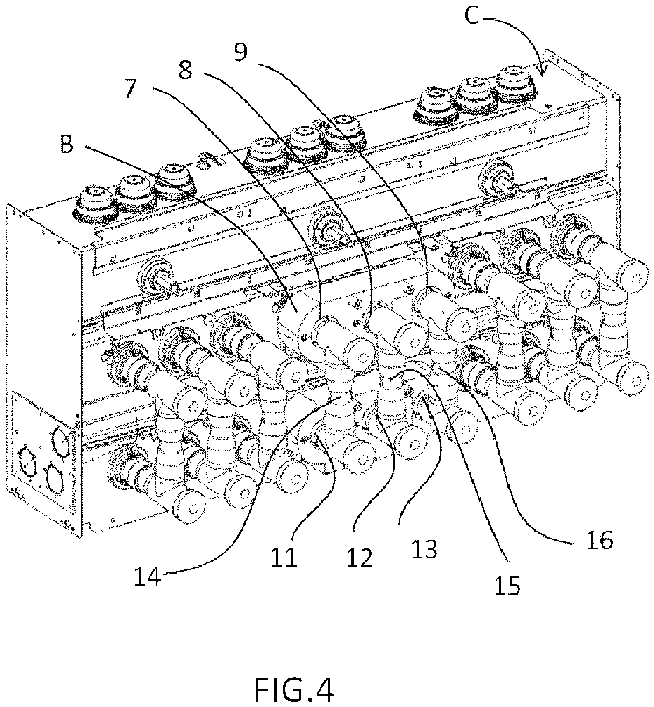

Tel qu'illustré sur la figure 4, ce capteur de protection est sous la forme d'un capteur à tore basse tension logé dans un bloc B surmoulé en résine, et monté autour de traversées 7,8,9 appartenant à un jeu de traversées montées en sortie du disjoncteur 1.

Le courant, lors de ce test, traverse directement ce capteur de courant de protection 6 sur son circuit primaire.

Tel qu'illustré sur les figures 1 et 4, selon une réalisation avantageuse de l'invention, cet appareillage comporte, en série avec le capteur de courant de protection précité 6, un capteur de courant de mesure 10 apte à réaliser le comptage du courant destiné à être fourni à un distributeur par le client, ce capteur de mesure 10, également sous la forme d'un capteur à tore basse tension logé dans un bloc surmoulé, étant monté autour d'un second jeu de traversées 11,12,13 associé au disjoncteur.

Les traversées 7,8 et 9 du jeu de traversées dit principal précité sont reliées électriquement et mécaniquement aux traversées 11,12 et 13 du jeu de traversées dit secondaire, par respectivement trois barres 14,15 et 16 appartenant à un jeu de barres électriquement isolé et blindé

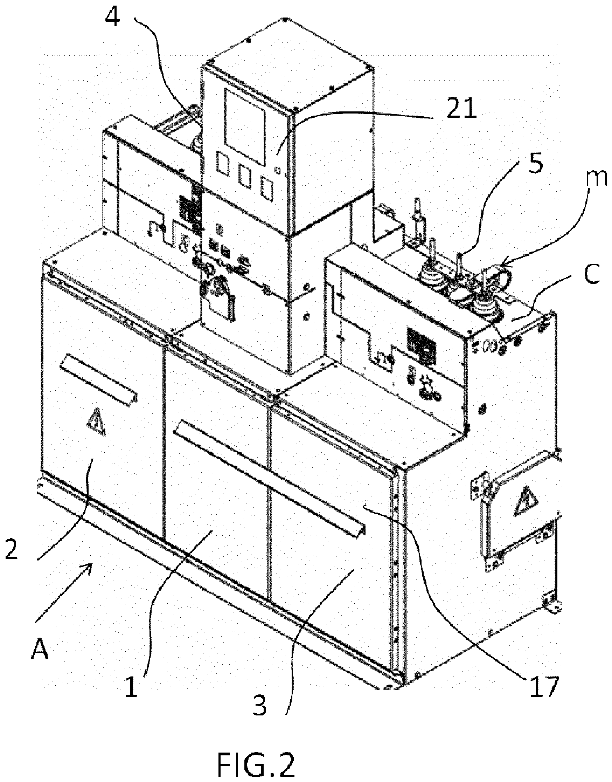

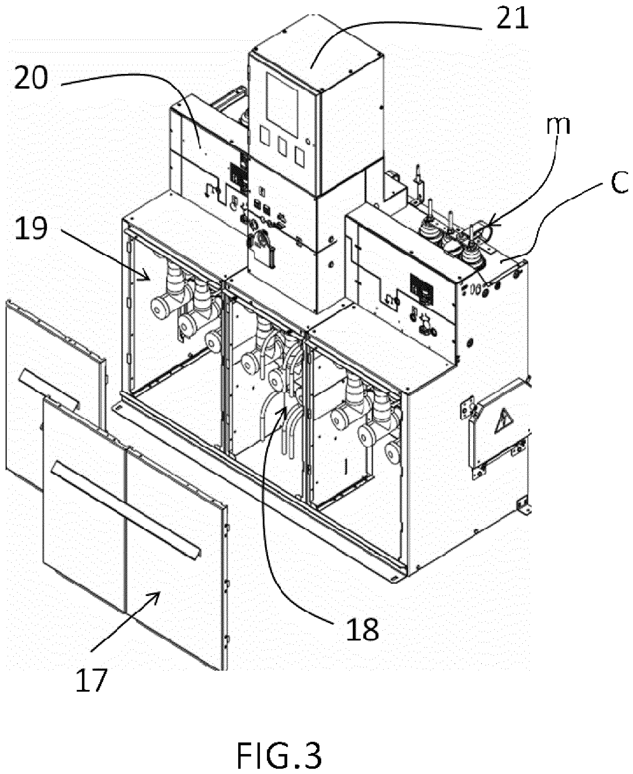

Sur les figures 2 et 3, on peut voir que les trois appareils 1,2 et 3 sont logés dans une cuve C avec des compartiments et comportant sur sa face avant plusieurs panneaux 17 d'accès à l'intérieur des compartiments, en particulier aux transformateurs 18 pour ce qui concerne le disjoncteur. Cette cuve comporte également un compartiment 19 pour le jeu de barres, un plastron de commande 20 comportant le synoptique et un caisson basse tension 21 contenant un relais de protection en façade.

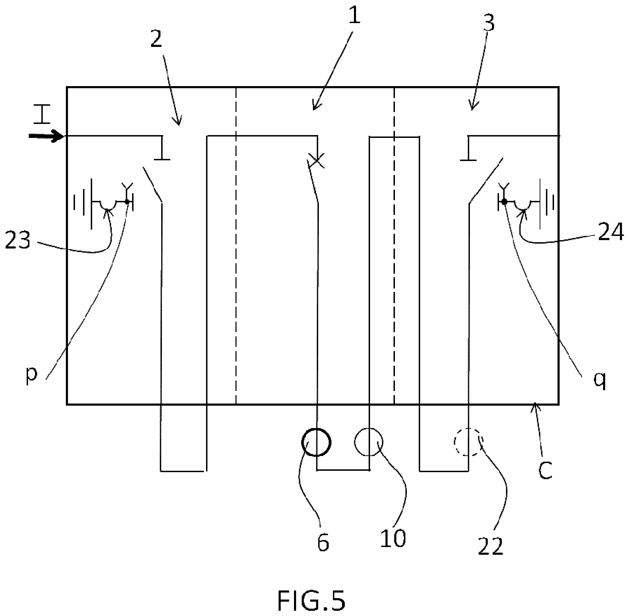

La figure 5 illustre un mode de réalisation particulier d'un appareillage moyenne tension A selon l'invention dans lequel le départ est à droite, et l'appareillage étant en dehors du mode test. Dans cette réalisation, l'appareillage comporte de gauche à droite, un sectionneur amont 2, un disjoncteur 1, et un sectionneur aval 3, ces trois appareils étant montés en série. Le disjoncteur 1 comporte en aval un capteur de courant de protection 6 et un capteur de courant de mesure 10 montés en série, le premier étant relié au relais du disjoncteur tandis que le second sert au comptage du courant par le distributeur. Un autre capteur de mesure du courant 22 est également prévu en aval du capteur de mesure de protection 6, et est destiné à permettre le comptage du courant par le client par exemple lors de la revente de l'électricité par le client dans le cadre des énergies renouvelables.

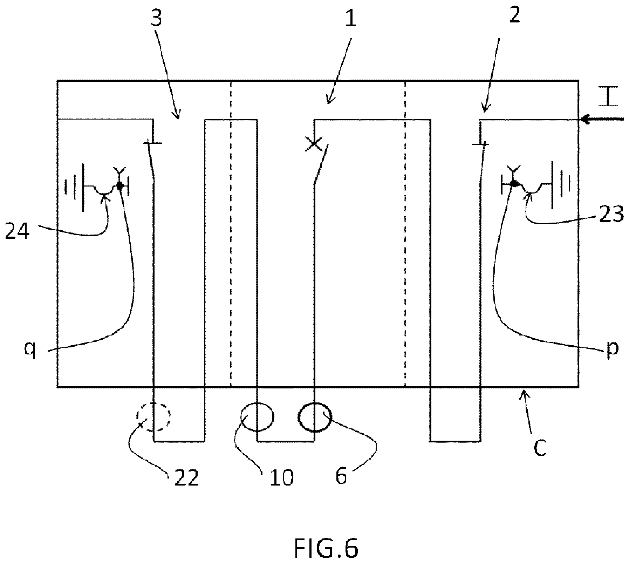

La figure 6 représente un autre mode de réalisation de l'invention dans lequel l'appareillage, étant également en dehors du mode test, comporte les mêmes éléments que l'appareil illustré sur la figure 5, le départ de l'appareillage étant cette fois à gauche.

La figure 7 représente le même appareillage que sur la figure 5, en mode test cette fois, c'est-à-dire pendant l'injection du courant primaire et avec en même temps la mesure du courant circulant dans le circuit principal.

Le procédé selon un mode de réalisation de l'invention va être décrit dans ce qui suit :
Tout d'abord, l'on ouvre le disjoncteur 1, puis le sectionneur amont 2, puis le sectionneur aval 3. Puis, l'on ferme les circuits de mise à la terre T amont et aval. Puis, l'on vient brancher l'équipement de test sur les doigts d'injection 4,5. Puis, l'on ferme le disjoncteur 1. Puis, l'on enlève les deux collecteurs de terre 23,24, puis l'on injecte le courant. Ce courant est injecté à la valeur souhaitée correspondant à la valeur de la protection demandée. On s'assure ensuite que le disjoncteur 1 ouvre bien à la bonne valeur de courant. Puis, l'on effectue la manoeuvre inverse.

Selon la réalisation précédemment décrite, les moyens de mise à la terre sont constitués par le fait que les sectionneurs respectivement amont et aval possèdent eux-mêmes une troisième position.

Selon une autre réalisation non décrite, ces moyens de mise à la terre pourront être réalisés par deux sectionneurs de terre supplémentaires placés respectivement en aval des deux sectionneurs amont et aval de l'appareillage.

L'invention permet ainsi de réaliser un test direct complet de l'ensemble de la chaîne de protection par injection d'un courant sur le primaire du relais, sans spire ou artifice supplémentaire à travers le capteur de courant. Ce procédé de test ne nécessite plus l'ouverture des compartiments, d'où une bonne tenue aux ambiances sévères, et peut se réaliser à partir de l'extérieur de l'appareillage devant la façade avant.

Cette invention permet d'injecter une valeur de courant précise à l'aide d'une source de courant.

L'invention s'applique avantageusement à tous les appareils de protection électriques moyenne tension ne permettant pas une injection directe.

Bien entendu, l'invention n'est pas limitée aux modes de réalisation décrits et illustrés qui n'ont été donnés qu'à titre d'exemple. L'invention est limitée par les revendications.

C'est ainsi par exemple que les sectionneurs amont et aval pourront être des sectionneurs simples, ou bien des interrupteur-sectionneurs ou bien tout type d'appareil comportant des moyens de sectionnement.

## Revendications

1. Procédé pour tester l'ensemble de la chaîne de protection dans un appareillage de protection électrique moyenne tension à isolation gazeuse, ledit appareillage comportant un disjoncteur,
**caractérisé en ce qu'**il consiste à placer en amont et en aval du disjoncteur (1) respectivement un sectionneur amont (2) et un sectionneur aval (3), lesdits sectionneurs (2,3) étant montés en série avec le disjoncteur (1), ledit disjoncteur (1) comportant en aval un capteur de courant de protection (6), puis dans une première étape, après avoir ouvert les trois appareils, à brancher des moyens d'injection d'une source de courant en un point de raccordement électrique (p) dit premier, du circuit électrique du sectionneur dit amont (2), puis dans une seconde étape, après avoir fermé le disjoncteur, à injecter un courant en ce premier point de raccordement (p), ce courant étant destiné à traverser le circuit principal du disjoncteur, puis dans une troisième étape, en même temps que l'injection du courant, à mesurer le courant circulant entre ce premier point de raccordement et un second point de raccordement (q) situé sur le circuit électrique du second sectionneur dit aval (3), le courant lors de ce test, traversant directement ce capteur de courant de protection (6) sur son circuit primaire, et enfin à s'assurer que le disjoncteur (1) s'ouvre bien à la valeur souhaitée.

2. Procédé selon la revendication 1, **caractérisé en ce que** l'on injecte ce courant sur des doigts d'injection (4) initialement présents sur le circuit électrique du sectionneur amont (2), lesquels étant initialement prévus pour réaliser le test des câbles par injection d'une tension dite de test des câbles.

3. Procédé selon la revendication 1 ou 2, **caractérisé en ce que** les deux sectionneurs précités comportent chacun des moyens (m) de mise à la terre (T) du circuit correspondant, **en ce que** les points de raccordement électriques précités (p,q) sont situés respectivement sur les circuits de mise à la terre correspondant à ces moyens de mise à la terre, et **en ce que** préalablement au branchement des moyens d'injection, les deux circuits électriques de mise à la terre sont fermés.

4. Procédé selon la revendication 3, **caractérisé en ce que** la mise à la terre s'effectue, pour chacun des sectionneurs, par l'intermédiaire d'un collecteur (23,24) interposé entre la terre (T) et le point de raccordement correspondant (p,q), et **en ce que** préalablement à l'injection de courant et après la fermeture du disjoncteur (1), les collecteurs précités sont retirés.

5. Procédé selon l'une quelconque des revendications précédentes,
**caractérisé en ce que** les sectionneurs respectivement amont et aval sont des sectionneurs comportant une position de mise à la terre (T).

6. Procédé selon l'une quelconque des revendications 1 à 4, **caractérisé en ce que** les sectionneurs amont (2) et aval (3) sont reliés électriquement en aval respectivement à un sectionneur de terre amont et à un sectionneur de terre aval, lesdits sectionneurs de terre étant reliés électriquement à la terre (T) respectivement au moyen d'un collecteur de terre (23,24), **caractérisé en ce que** dans la première étape , l'on ouvre tout d'abord le disjoncteur, puis le sectionneur amont, puis le sectionneur aval, puis l'on ferme le sectionneur de terre amont, puis l'on ferme le sectionneur de terre aval, puis l'on vient brancher les moyens d'injection précités sur le premier point de raccordement.

7. Procédé selon la revendication 6, **caractérisé en ce que** lors de la seconde étape, l'on ferme le disjoncteur (1), l'on retire les collecteurs de terre (23,24) de manière que les circuits de mise à la terre soient ouverts, et l'on injecte le courant.

8. Appareillage de protection électrique moyenne tension configuré pour la mise en oeuvre d'un procédé selon l'une quelconque des revendications précédentes, comportant un disjoncteur (1) monté en série en amont avec un sectionneur dit amont (2), **caractérisé en ce que** ledit disjoncteur est monté en série en aval avec un sectionneur dit aval (3), **en ce que** ledit disjoncteur (1) comporte en aval un capteur de courant de protection (6), et **en ce que** ledit appareillage comporte au moins un doigt d'injection (4) situé(s) en un point de raccordement électrique (p) dit premier situé sur le circuit électrique du sectionneur dit amont (2), au moins un doigt d'injection (4) situé(s) en un point de raccordement électrique (q) dit second situé sur le circuit électrique du sectionneur dit aval (3), un moyen d'injection d'un courant sur le premier point de raccordement électrique, et un moyen de mesure M du courant circulant entre le point de raccordement dit premier (p) et le point de raccordement électrique dit second (q).

9. Appareillage selon la revendication 8, **caractérisé en ce que** les sectionneurs amont et aval précités (2,3) sont des sectionneurs à trois positions comportant une position de mise à la terre T.

10. Appareillage de protection électrique moyenne tension selon la revendication 8, **caractérisé en ce que** les deux sectionneurs respectivement amont et aval (2,3) sont reliés électriquement respectivement en aval à deux sectionneurs de terre respectivement amont et aval par l'intermédiaire respectivement d'un collecteur de terre amont (23) et d'un collecteur de terre aval (24).

11. Appareillage selon l'une quelconque des revendications 8 à 10, **caractérisé en ce qu'**il comporte un capteur de protection (6) disposé à la sortie du disjoncteur (1), le courant lors du test traversant alors directement le capteur (6) sur son circuit primaire.

12. Appareillage selon la revendication 11, **caractérisé en ce que** le capteur de protection (6) est du type à basse tension, est monté autour des traversées (7,8,9) appartenant à un premier jeu de traversées associées au disjoncteur (1), et comporte un second capteur dit de mesure (10) de courant également du type à basse tension et monté autour d'un second jeu de traversées (11,12,13) relié électriquement et mécaniquement phase par phase au premier jeu de traversées (7,8,9), par l'intermédiaire d'un jeu de barre isolé blindé (14,15,16).

## Patentansprüche

1. Verfahren zum Testen der gesamten Schutzkette in einem elektrischen Mittelspannungsschutzgerät mit Gasisolierung, wobei das Gerät einen Schutzschalter umfasst,
**dadurch gekennzeichnet, dass** dieses daraus besteht, jeweils stromaufwärts und stromabwärts von dem Schutzschalter (1) einen stromaufwärtigen Trennschalter (2) und einen stromabwärtigen Trennschalter (3) zu platzieren, wobei die Trennschalter (2, 3) in Serie mit dem Schutzschalter (1) montiert sind, wobei der Schutzschalter (1) stromabwärts einen Stromschutzsensor (6) umfasst, dann in einem ersten Schritt, nachdem die drei Vorrichtungen geöffnet wurden, Mittel zum Injizieren einer Stromquelle an einem als erster bezeichneten elektrischen Verbindungspunkt (p) der elektrischen Schaltung des als stromaufwärtig bezeichneten Trennschalters (2) zu verzweigen, dann in einem zweiten Schritt, nachdem der Schutzschalter geschlossen wurde, einen Strom an diesem ersten Verbindungspunkt (p) zu injizieren, wobei dieser Strom dazu bestimmt ist, die Hauptschaltung des Schutzschalters zu durchqueren, dann in einem dritten Schritt, gleichzeitig mit dem Injizieren des Stroms, den Strom zu messen, der zwischen diesem ersten Verbindungspunkt und einem zweiten Verbindungspunkt (q), der an der elektrischen Schaltung des als stromabwärtig bezeichneten zweiten Trennschalters (3) angeordnet ist, zirkuliert, wobei der Strom bei diesem Test direkt diesen Stromschutzsensor (6) in seiner primären Schaltung durchquert, und schließlich sicherzustellen, dass sich der Schutzschalter (1) gut bei dem gewünschten Wert öffnet.

2. Verfahren nach Anspruch 1,
**dadurch gekennzeichnet, dass** dieser Strom in Injektionsfingern (4) injiziert wird, die anfänglich auf der elektrischen Schaltung des stromaufwärtigen Trennschalters (2) vorhanden sind, wobei diese anfänglich bereitgestellt werden, um den Test von Kabeln durch Injizieren einer Spannung vorzunehmen, die als Kabeltestspannung bezeichnet wird.

3. Verfahren nach Anspruch 1 oder 2,
**dadurch gekennzeichnet, dass** die beiden vorgenannten Trennschalter jeweils Mittel (m) zum Erden (T) der entsprechenden Schaltung umfassen, dadurch, dass die vorgenannten elektrischen Verbindungspunkte (p, q) jeweils an den Erdungsschaltungen angeordnet sind, die diesen Erdungsmitteln entsprechen, und dadurch, dass vor der Verzweigung der Injektionsmittel die beiden elektrischen Erdungsschaltungen geschlossen werden.

4. Verfahren nach Anspruch 3,
**dadurch gekennzeichnet, dass** das Erden, für jeden der Trennschalter, mit Hilfe eines Kollektors (23, 24) erfolgt, der zwischen Erde (T) und dem entsprechenden Verbindungspunkt (p, q) angeordnet ist, und dadurch, dass vor dem Injizieren des Stroms und nach dem Schließen des Schutzschalters (1) die vorgenannten Kollektoren zurückgezogen werden.

5. Verfahren nach einem der vorhergehenden Ansprüche,
**dadurch gekennzeichnet, dass** die Trennschalter jeweils stromaufwärts und stromabwärts Trennschalter sind, die eine Position zum Erden (T) umfassen.

6. Verfahren nach einem der Ansprüche 1 bis 4,
**dadurch gekennzeichnet, dass** der stromaufwärtige (2) und stromabwärtige (3) Trennschalter elektrisch stromabwärts jeweils mit einem stromaufwärtigen Erdungstrennschalter und einem stromabwärtigen Erdungstrennschalter verbunden sind, wobei die Erdungstrennschalter elektrisch jeweils mit Hilfe eines Erdungskollektors (23, 24) mit Erde (T) verbunden sind,
**dadurch gekennzeichnet, dass** in dem ersten Schritt zuerst der Schutzschalter geöffnet wird, dann der stromaufwärtige Trennschalter, dann der stromabwärtige Trennschalter, dann der stromaufwärtige Erdungstrennschalter geschlossen wird, dann der stromabwärtige Erdungstrennschalter geschlossen wird, dann die vorgenannten Injektionsmittel an dem ersten Verbindungspunkt verzweigt werden.

7. Verfahren nach Anspruch 6,
**dadurch gekennzeichnet, dass** in dem zweiten Schritt der Schutzschalter (1) geschlossen wird, die Erdungskollektoren (23, 24) derart zurückgezogen werden, dass die Erdungsschaltungen geöffnet werden, und der Strom injiziert wird.

8. Gerät zum elektrischen Mittelspannungsschutz, welches für die Vornahme eines Verfahrens nach einem der vorhergehenden Ansprüche ausgelegt ist, umfassend einen Schutzschalter (1), der in Serie stromaufwärts mit einem als stromaufwärtig bezeichneten Trennschalter (2) montiert ist,
**dadurch gekennzeichnet, dass** der Schutzschalter in Serie stromabwärts mit einem als stromabwärtig bezeichneten Trennschalter (3) montiert ist, dadurch, dass der Schutzschalter (1) stromabwärts einen Stromschutzsensor (6) umfasst, und dadurch, dass das Gerät umfasst: mindestens einen Injektionsfinger (4), der (die) an einem als erster bezeichneten elektrischen Verbindungspunkt (p) angeordnet ist (sind), welcher an der elektrischen Schaltung des als stromaufwärtig bezeichneten Trennschalters (2) angeordnet ist, mindestens einen Injektionsfinger (4), der (die) an einem als zweiter bezeichneten elektrischen Verbindungspunkt (q) angeordnet ist (sind), welcher an der elektrischen Schaltung des als stromabwärtig bezeichneten Trennschalters (3) angeordnet ist, ein Mittel zum Injizieren eines Stroms an dem ersten elektrischen Verbindungspunkt, und ein Mittel zum Messen M des Stroms, der zwischen dem als erster bezeichneten Verbindungspunkt (p) und dem als zweiter bezeichneten elektrischen Verbindungspunkt (q) zirkuliert.

9. Gerät nach Anspruch 8,
**dadurch gekennzeichnet, dass** der vorgenannte stromaufwärtige und stromabwärtige Trennschalter (2, 3) Trennschalter mit drei Positionen sind, umfassend eine Erdungsposition T.

10. Gerät zum elektrischen Mittelspannungsschutz nach Anspruch 8,
**dadurch gekennzeichnet, dass** die beiden Trennschalter jeweils stromaufwärts und stromabwärts (2, 3) jeweils elektrisch stromabwärts mit zwei Erdungstrennschaltern jeweils stromaufwärts und stromabwärts mit Hilfe jeweils eines stromaufwärtigen Erdungskollektors (23) und eines stromabwärtigen Erdungskollektors (24) verbunden sind.

11. Gerät nach einem der Ansprüche 8 bis 10,
**dadurch gekennzeichnet, dass** dieses einen Schutzsensor (6) umfasst, der am Ausgang des Schutzschalters (1) angeordnet ist, wobei der Strom während des Tests daher direkt den Sensor (6) in seiner primären Schaltung durchquert.

12. Gerät nach Anspruch 11,
**dadurch gekennzeichnet, dass** der Schutzsensor (6) vom Typ mit niedriger Spannung ist, rund um Durchführungen (7, 8, 9) montiert ist, welche zu einem ersten Satz von Durchführungen gehören, die mit dem Schutzschalter (1) assoziiert sind, und einen zweiten als Messer bezeichneten Stromsensor (10) ebenfalls vom Typ mit niedriger Spannung umfasst, der rund um einen zweiten Satz von Durchführungen (11, 12, 13) montiert ist, und der elektrisch und mechanisch Phase für Phase mit dem ersten Satz von Durchführungen (7, 8, 9) mit Hilfe einer gekapselten isolierten Sammelschiene (14, 15, 16) verbunden ist.

## Claims

1. Method for testing the whole of the protection chain in a gas-insulation medium-voltage electrical protection appliance, said appliance comprising a circuit breaker,
**characterized in that** it consists in placing upstream and downstream of the circuit breaker (1) an upstream disconnector (2) and a downstream disconnector (3) respectively, said disconnectors (2,3) being mounted in series with the circuit breaker (1), said circuit breaker (1) including, downstream, a protection current sensor (6), then in a first step, after having opened the three devices, in connecting injecting means of a source of current at a so-called first electrical connection point (p) of the electrical circuit of the so-called upstream disconnector (2), then in a second step, after having closed the circuit breaker, in injecting a current at this first connection point (p), this current being intended to flow through the main circuit of the circuit breaker, then in a third step, at the same time as the current is injected in measuring the current flowing between this first connection point and a second connection point (q) situated on the electrical circuit of the second, so-called downstream, disconnector (3), the current during this test, flowing directly through this protection current sensor (6) over its primary circuit, and finally in ensuring that the circuit breaker (1) does indeed open at the desired value.

2. Method according to Claim 1, **characterized in that** this current is injected on injection fingers (4) initially present on the electrical circuit of the upstream disconnector (2), which are initially provided to carry out the testing of cables by injection of a so-called cable test voltage.

3. Method according to Claim 1 or 2, **characterized in that** the two aforementioned disconnectors each comprise means (m) for earthing (T) the corresponding circuit, **in that** the aforementioned electrical connection points (p,q) are situated respectively on the earthing circuits corresponding to these earthing means, and **in that** prior to the connection of the injecting means, the two electrical earthing circuits are closed.

4. Method according to Claim 3, **characterized in that** the earthing is carried out, for each of the disconnectors, by way of a collector (23,24) interposed between the earth (T) and the corresponding connection point (p,q), and **in that** prior to the injection of current and after the closure of the circuit breaker (1), the aforementioned collectors are removed.

5. Method according to any one of the preceding claims, **characterized in that** the disconnectors respectively upstream and downstream are disconnectors comprising an earthing position (T).

6. Method according to any one of Claims 1 to 4, **characterized in that** the disconnectors upstream (2) and downstream (3) are electrically linked downstream respectively to an upstream earth disconnector and to a downstream earth disconnector, said earth disconnectors being electrically linked to the earth (T) respectively by means of an earth collector (23,24), **characterized in that** in the first step, the circuit breaker is opened first of all, then the upstream disconnector, then the downstream disconnector, then the upstream earth disconnector is closed, then the downstream earth disconnector is closed, then the aforementioned injecting means are connected to the first connection point.

7. Method according to Claim 6, **characterized in that** in the second step, the circuit breaker (1) is closed, the earth collectors (23,24) are removed in such a way that the earthing circuits are open, and the current is injected.

8. Medium-voltage electrical protection appliance configured for the implementation of a method according to any one of the preceding claims, comprising a circuit breaker (1) mounted in series upstream with a so-called upstream disconnector (2), **characterized in that** said circuit breaker (1) is mounted in series downstream with a so-called downstream disconnector (3), **in that** said circuit breaker (1) includes, downstream, a protection current sensor (6), and **in that** said appliance includes at least one injection finger (4) situated at a so-called first electrical connection point (p) situated on the electrical circuit of the so-called upstream disconnector (2), at least one injection finger (4) situated at a so-called second electrical connection point (q) situated on the electrical circuit of the so-called downstream disconnector (3), a means for injecting a current into the first electrical connection point, and a means M for measuring the current flowing between the so-called first connection point (p) and the so-called second electrical connection point (q).

9. Appliance according to Claim 8, **characterized in that** the aforementioned upstream and downstream disconnectors (2,3) are three-position disconnectors comprising an earthing position T.

10. Medium-voltage electrical protection appliance according to Claim 8, **characterized in that** the two disconnectors, upstream and downstream respectively (2,3) are electrically linked respectively downstream to two earth disconnectors, upstream and downstream respectively, by way of an upstream earth collector (23) and a downstream earth collector (24) respectively.

11. Appliance according to any one of Claims 8 to 10, **characterized in that** it comprises a protection sensor (6) arranged at the output of the circuit breaker (1), the current during the test then directly crossing the sensor (6) on its primary circuit.

12. Appliance according to Claim 11, **characterized in that** the protection sensor (6) is of the low-voltage type, is mounted around feedthroughs (7,8,9) belonging to a first set of feedthroughs associated with the circuit breaker (1), and comprises a second so-called measurement (10) current sensor also of the low-voltage type and mounted around a second set of feedthroughs (11, 12, 13) electrically and mechanically linked phase by phase to the first set of feedthroughs (7,8,9), by way of an insulated and shielded busbar (14,15,16).
